Europäisches Patentamt

(19) European Patent Office

Office européen des brevets

(11) Veröffentlichungsnummer: **0 073 889**
**B1**

(12) **EUROPÄISCHE PATENTSCHRIFT**

(45) Veröffentlichungstag der Patentschrift:
13.01.88

(51) Int. Cl.⁴: **H 01 L 27/14, H 01 L 31/10**

(21) Anmeldenummer: 82105539.9

(22) Anmeldetag: 24.06.82

(54) Monolithische Eingangsstufe eines optischen Empfängers.

(30) Priorität: 08.09.81 DE 3135462

(43) Veröffentlichungstag der Anmeldung:
16.03.83 Patentblatt 83/11

(45) Bekanntmachung des Hinweises auf die Patenterteilung:
13.01.88 Patentblatt 88/2

(84) Benannte Vertragsstaaten:
AT CH DE FR GB IT LI NL SE

(56) Entgegenhaltungen:
US-A-3 761 326

PATENTS ABSTRACTS OF JAPAN, Band 5, Nr. 145
(E-74) 817 , 12. September 1981; & JP - A - 56 90 179
(NIPPON DENKI K.K.) 01-07-1981
ELECTRONICS LETTERS, Band 16, Nr. 23, 6.
November 1980, Seiten 893-895, London, GB; F.
CAPASSO u.a.: "InGaAsP/InGaAs heterojunction
p-i-n detectors with low dark current and small
capacitance for 1.3-1.6 mum fibre optic systems
ELECTRONICS LETTERS, Band 16, Nr. 10, 8. Mai
1980, Seiten 353-355, London, GB; R.F. LEHENY u.a.:
"Integrated In0.53Ga0.47As p-i-n F.E.T.
photoreceiver"
ELECTRONICS LETTERS, Band 15, Nr. 20, 27.
September 1979, Seiten 655-657, London, GB; C.
BURRUS u.a.: "InGaAsP p-i-n photodiodes with
low dark current and small capacitance"

(73) Patentinhaber: ANT Nachrichtentechnik GmbH,
Gerberstrasse 33, D-7150 Backnang (DE)

(72) Erfinder: Schwaderer, Bernhard, Dr.- Ing., Am
Brüdenrain 8, D-7153 Weissach im Tal (DE)

## Beschreibung

Die vorliegende Erfindung betrifft eine als Monolith aufgebaute Eingangsstufe eines optischen Empfängers, bestehend aus einer PIN-Photodiode, einem daran angeschlossenen Feldeffekttransistor und einen gemeinsamen Träger, der aus einem halbisolierenden InP-Substrat gebildet ist.

Eine derartige Eingangsstufe ist aus Electronics Letters, Vol.16, No.10, 8.Mai 1980, s. 353-355 bekannt.

Bisher wurden in der Eingangsstufe von breitbandigen optischen Empfängern für Lichtleitfaser-Übertragungssysteme meistens Lawinenphotodioden eingesetzt wegen ihrer relativ hohen Empfindlichkeit. Die Regelung der Lawinenverstärkung solcher Photodioden ist nur mit sehr aufwendigen Schaltungen realisierbar. Außerdem ist es erforderlich, die Lawinenphotodiode aufgrund ihrer hohen Versorgungsspannung gegenüber der nachfolgenden Verstärkerschaltung kapazitiv abzublocken. Diese Maßnahme bringt aber unerwünschte Streureaktanzen mit sich, die eine Verminderung der Bandbreite des Empfängers zur Folge haben.

In den beiden Veröffentlichungen "Receivers for optical communications: a comparison of avalanche photodiodes with PIN-FET hybrids", Optical & Quantum Electr. 10, 1978, pp. 293 bis 300 und

"PIN-FET hybrid optical receivers for longer wavelength optical communication systems", 6th Europ. Conf. on Opt. Communication, York, 1980

ist nachgewiesen worden, daß mit einer PIN-Photodiode und einem daran angeschlossenen Feldeffekttransistor (FET) im Eingang eines optischen Empfängers bei gleicher Bandbreite eine mindestens genauso hohe Empfängerempfindlichkeit erreicht werden kann wie mit einer Lawinenphotodiode. PIN-Photodioden sind mit den nachgeschalteten aktiven Halbleiterbauelementen (Bipolare -, Feldeffekttransistoren etc.) spannungskompatibel, d.h., es sind keine Abblockmaßnahmen erforderlich, die sich negativ auf die Bandbreite des Empfängers auswirken könnten. Zudem erfordern PIN-Photodioden im Gegensatz zu Lawinenphotodioden keine aufwendige Regelschaltung zur Stabilisierung der Dioden-Sperrspannung.

Um den Einsatz einer Lawinenphotodiode in einem optischen Empfänger zu umgehen und dennoch eine hohe Eingangsempfindlichkeit zu erzielen, sind an die PIN-Photodiode und den Feldeffekttransistor in der Eingangsstufe folgende Forderungen zu stellen:

Es muß eine sehr kapazitätsarme PIN-Photodiode mit hoher Quantenausbeute und geringem Dunkelstrom gewählt werden. Außerdem soll der Feldeffekttransistor einen möglichst geringen Gate-Leckstrom aufweisen, eine große Steilheit und eine kleine Gate-Source-Kapazität besitzen. Schließlich ist darauf zu achten, Reaktanzen, die durch die elektrische Verbindung zwischen der PIN-Photodiode und dem Feldeffekttransistor entstehen so klein wie möglich zu halten, um die Grenzfrequenz des Empfängers weiter heraufzusetzen und ihn damit für höchste Bitraten einsetzen zu können.

Speziell in der Erfüllung dieser Forderungen liegt die Aufgabe der Erfindung.

Sie werden erfindungsgemäß dadurch gelöst, daß die PIN-Photodiode eine Absorptionszone für die optische Strahlung aus GaInAsP und einen aus InP-Schichten gebildeten pn-Übergang besitzt und auf eine auf dem halbisolierenden InP-Substrat angeordnete n⁻-InP-Schicht aufgebracht ist, wobei die n⁻-InP-Schicht gleichzeitig die aktive Zone des Feldeffekttransistors darstellt.

Zweckmäßige Ausführungen der Erfindung gehen aus den Unteransprüchen hervor.

Der Vorteil des monolithischen Aufbaus der Empfängereingangsstufe nach der Erfindung liegt nun zum einen in der geringen, kontrollierbaren Streureaktanz, in der Reproduzierbarkeit und zum anderen in der kostengünstigen Herstellung der Schaltung.

Anhand eines in der Zeichnung dargestellten Ausführungsbeispiels wird nun die Erfindung näher erläutert. Es zeigen:

Figur 1 die PIN-Photodiode und
Figur 2 den MES-Feldeffekttransistor getrennt für sich,
Figur 3 den monolithischen Aufbau beider und
Figur 4 die Ersatzschaltung dieses monolithischen Aufbaus.

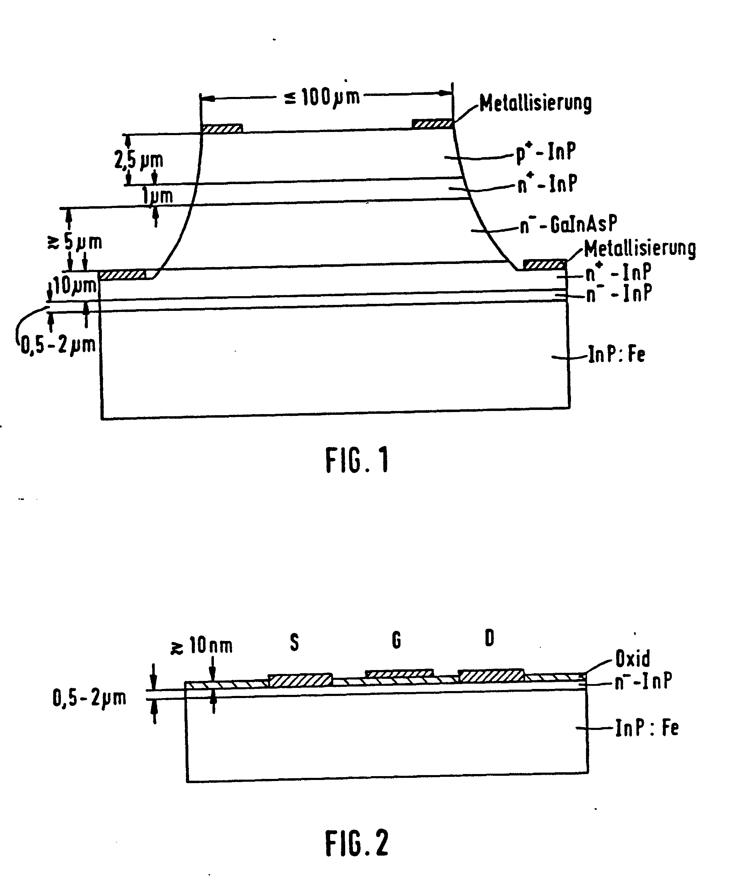

In der Figur 1 ist ein PIN-Photodiode dargestellt, die für einen monolithischen Aufbau zusammen mit dem später beschriebenen Feldeffekttransistor geeignet ist. Diese PIN-Photodiode setzt sich aus folgenden Epitaxieschichten zusammen: Ihre beiden obersten Schichten bilden den pn-Übergang und bestehen aus p+/n+-InP. Darauf folgt für die optische Strahlung die Absorptionszone aus n⁻-GaInAsP, woran sich eine n+-InP-Schicht anschließt. Die letztere Schicht dient als niederohmige Kontaktierungszone. Für die Kontaktierung der einen Elektrode besitzt die n+-InP einen planaren Bereich, auf dem eine Metallisierung aufgebracht ist. Die Kontaktierung der anderen Elektrode erfolgt auf der planaren, obersten p+-InpSchicht.

Dadurch, daß der pn-Übergang in einer Zone (p+-InP/n+-InP) mit großem Bandabstand liegt, stellt sich ein nur geringer Dioden-Dunkelstrom ein. Tunnelströme sind daher im allgemeinen gegen die Generations- und Rekombinationsströme als Bestandteile des Dunkelstroms vernachlässigbar. Der Dunkelstrom für eine PIN-Photodiode, deren Epitaxieschichten die in der Figur 1 aufgezeigten Abmessungen besitzen, liegt etwa bei 10nA. Die Sperrschichtkapazität dieser Diode beträgt ungefähr 0,5 pF bei einem Diodendurchmesser

von ≈ 100 μm. Sie ließe sich durch eine Reduzierung des Durchmessers noch weiter verringern.

Die oben beschriebene Schichtenfolge der PIN-Photodiode ist auf einem Träger aufgebracht, der aus einem mit einer dünnen (0,5 bis 2 μm) n⁻-InP-Schicht bedeckten Substrat aus mit Fe dotierten InP besteht.

Den gleichen Träger besitzt auch der in der Figur 2 dargestellte MES-FET, wobei die n⁻-InP-Schicht als aktive Zone für den Feldeffekttransistor wirkt. Auf dieser aktiven Zone befinden sich die Kontaktierungen für Source und Drain, wogegen das Gate von der aktiven Zone durch eine Oxid-Schicht getrennt ist. Bei einer ca. 10 nm dicken Oxid-Schicht stellt sich eine hohe Potentialbarriere (Schottky-Barriere) zwischen dem InP und dem Au-Gate von etwa 0,8 bis 0,9 eV ein.

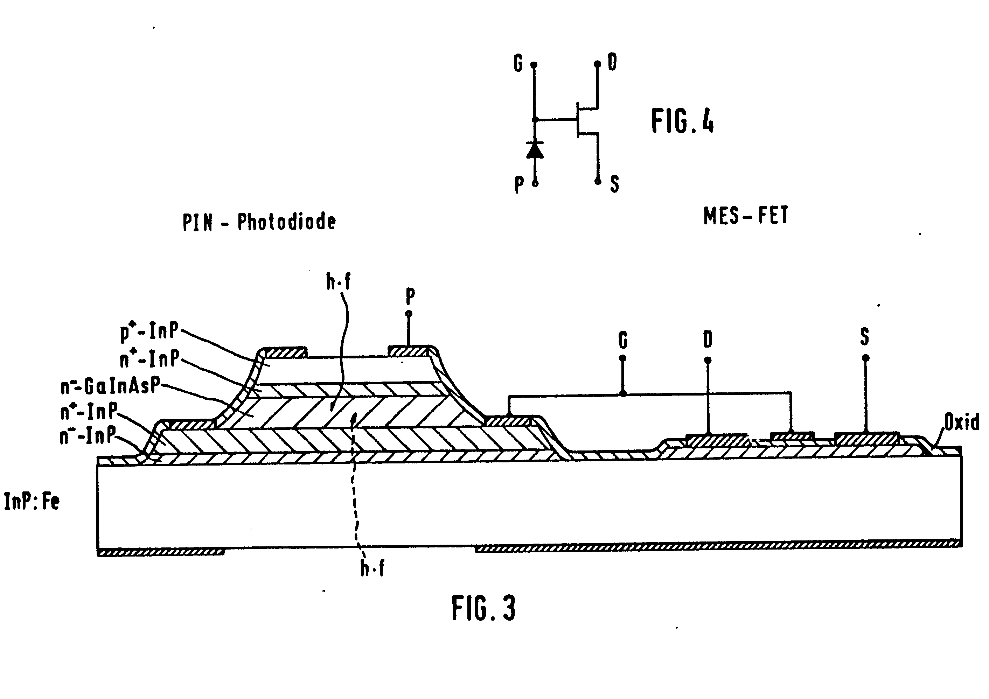

Den monolithischen Aufbau der zuvor beschriebenen PIN-Photodiode und des MES-FET mit dünnem Gate-Oxid zeigt die Figur 3. Die beispielhaft gewählte Ausführung für die Zusammenschaltung beider ist dem Ersatzschaltbild in Figur 4 zu entnehmen.

Bei Verwendung einer dickeren Oxidschicht ergibt sich aus dem MES-FET ein MIS-FET.

Wird durch die Gatemetallisierung anstelle des Oxids eine flache p-Dotierung im n⁻-InP kontaktiert, so ergibt sich ein Sperrschicht-FET.

Da das InP für Wellenlänge $\lambda > 1$ μm transparent ist, kann die Photodiode von der Oberseite oder von der Unterseite bestrahlt werden. Die Bestrahlung von der Unterseite ermöglicht die Realisierung sehr kleinflächiger Photodioden mit geringsten Sperrschichtkapazitäten.

**Patentansprüche**

1. Als Monolith aufgebaute Eingangsstufe eines optischen Empfängers, bestehend aus einer PIN-Photodiode einem daran angeschlossenen Feldeffekttransistor, und einem gemeinsamen Träger, der aus einem halbisolierenden InP-Substrat gebildet ist, dadurch gekennzeichnet, daß die PIN-Photodiode eine Absorptionszone für die optische Strahlung aus GaInAsP und einen aus InP-Schichten gebildeten pn-Übergang besitzt und auf eine auf dem halbisilierenden InP-Substrat angeordnete n⁻-InP-Schicht aufgebracht ist wobei die n⁻-InP-Schicht gleichzeitig die aktive Zone des Feldeffekttransistors darstellt

2. Eingangsstufe nach Anspruch 1, gekennzeichnet durch folgende auf einem InP:Fe/n⁻-InP-Träger aufgebrachte Epitaxieschichtenfolge der PIN-Photodiode: n⁺-InP, n⁻-GaInAsP, n⁺-InP, p⁺-InP.

3. Eingangsstufe nach Anspruch 2, dadurch gekennzeichnet, daß die Dicke der n⁻-InP-Schicht 0,5 bis 2 μm, die der n⁺-InP-Schicht 10 μm, die der n⁻-GaInAsP-Schicht $\gtrsim$ 5 μm, die der n⁺-InP-

Schicht 1 μm und die der p⁺-InP-Schicht 2,5 μm beträgt und daß der Durchmesser der PIN-Photodiode $\leqslant$ 100 μm ist.

4. Eingangsstufe nach Anspruch 2, dadurch gekennzeichnet, daß die n⁺-InP-Schicht der PIN-Photodiode einen metallisierten Bereich besitzt als Gegenelektrode zu der die p⁺-InP-Schicht kontaktierenden Elektrode.

5. Eingangsstufe nach Anspruch 1, dadurch gekennzeichnet, daß der Feldeffekttransistor als n⁻-InP-Metall-Halbleiter-Feldeffekttransistor (MES-FET) ausgebildet ist.

6. Eingangsstufe nach Anspruch 5, dadurch gekennzeichnet, daß zwischen der n⁻-InP-Schicht und dem Gate des Feldeffekttransistors eine ca. 10 nm dicke Oxid-Schicht angeordnet ist.

7. Eingangsstufr nach Anspruch 1, dadurch gekennzeichnet, daß zwischen der n⁻-InP-Schicht und dem Gate des Feldeffekttransistors ein Isolator angeordnet ist (MIS-FET).

8. Eingangsstufe nach Anspruch 1, dadurch gekennzeichnet, daß der Feldeffekttransistor als pn-InP-Sperrschicht-Feldeffekttransistor ausgeführt ist.

**Claims**

1. Monolithically designed input stage in an optical receiver, comprising a PIN photodiode, a field effect transistor connected thereto, and a common carrier formed of a semi-insulating InP substrate, characterized in that the PIN photodiode includes an absorption zone of GaInAsP for the optical radiation and has a pn-junction which is formed of InP layers and is applied to an n⁻-InP layer disposed on the semi-insulating InP substrate, with the n⁻-InP layer simultaneously constituting the active zone of the field effect transistor.

2. Input stage according to claim 1, characterized by the following epitaxial layer sequence on the PIN photodiode applied on an InP:Fe/n⁻-InP carrier: n⁺-InP, n⁻-GaInAsP, n⁺-InP, p⁺-InP.

3. Input stage according to claim 2, characterized in that the thickness of the n⁻-InP layer is 0.5 to 2 μm, the thickness of the n⁺-InP layer is 10 μm, the thickness of the n⁻-GaInAsP layer is $\gtrsim$ 5 μm, the thickness of the n⁺-InP layer is 1 μm and the thickness of the p⁺-InP layer is 2.5 μm and the diameter of the PIN photodiode is $\leqslant$ 100 μm.

4. Input stage according to claim 2, characterized in that the n⁺-InP layer of the PIN photodiode has a metallized region which acts as a counterelectrode for the electrode contacted with the p⁺-InP layer.

5. Input stage according to claim 1, characterized in that the field effect transistor is configured as an n⁻-InP metal semiconductor field effect transistor (MES-FET).

6. Input stage according to claim 5, characterized in that an oxide layer approximately 10 nm thick is disposed between the n⁻-InP layer and the gate of the field effect transistor.

7. Input stage according to claim 1, characterized in that an isolator (MIS-FET) is disposed between the n⁻-InP layer and the gate of the field effect transistor.

8. Input stage according to claim 1, characterized in that the field effect transistor is configured as a pn-InP barrier layer field effect transistor.

## Revendications

1. Etage d'entrée réalisé comme une structure monolithique d'un récepteur optique, constitué d'une photodiode PIN, d'un transistor à effet de champ connecté à elle et d'un support commun qui est formé par un substrat semi-isolant en InP, caractérisé en ce que la photodiode PIN possède une zone d'absorption pour le rayonnement optique en GaInAsP et une jonction pn formée de couches de InP et est disposée sur une couche de InPn⁻ formée sur le substrat semi-isolant en InP, la couche de InPn⁻ représentant en même temps la zone active du transistor à effet de champ.

2. Etage d'entrée selon la revendication 1, caractérisé en ce que la photodiode PIN possède, sur un support en InP:Fe/inP n⁻, la succession suivante de couches épitaxiales : InP n+ , GaInAsP n⁻, InP n+ et InP p+.

3. Etage d'entrée selon la revendication 2, caractérisé en ce que l'épaisseur de la couche de InP n⁻ est de 0,5 à 2 μm, l'épaisseur de la couche de InP n+ suivante est de 10 μm, l'épaisseur de la couche de GaInAsP n⁻ suivante est supérieure ou environ égale à 5 μm, l'épaisseur de la couche de InP n+ suivante est de 1 μm et l'épaisseur de la couche de InP p+ mentionnée en dernier est de 2,5 μm, et que le diamétre de la photodiode PIN est inférieure ou égale à 100 μm.

4. Etage d'entrée selon la revendication 2, caractérisé en ce que la couche de InP n+ de la photodiode PIN possède une région métallisée en tant que contre-électrode par rapport à l'électrode en contact avec la couche de InP p+.

5. Etage d'entrée selon la revendication 1, caractérisé en ce que le transistor à effet de champ est réalisé comme un transistor à effet de champ métal-semiconducteur (MES-FET) au InP n⁻.

6. Etage d'entrée selon la revendication 5, caractérisé en ce qu'une couche d'oxyde d'une épaisseur d'environ 10 nm est disposée entre la couche de InP n⁻ et la grille du transistor effet de champ.

7. Etage d'entrée selon la revendication 1, caractérisé en ce qu'un isolateur est disposé entre la couche de InP n⁻ et la grille du transistor à effet de champ (MIS-FET).

8. Etage d'entrée selon la revendication 1, caractérisé en ce que le transistor à effet de champ est réalisé comme un transistor à effet de champ à couche de jonction pn au InP.

≤ 100 μm

Metallisierung

2,5 μm

1 μm

p⁺ - InP

n⁺ - InP

n⁻ - GaInAsP

≳ 5 μm

Metallisierung

10 μm

n⁺ - InP

n⁻ - InP

0,5 - 2 μm

InP : Fe

**FIG. 1**

≳ 10 nm

S    G    D

Oxid

n⁻ - InP

0,5 - 2 μm

InP : Fe

**FIG. 2**

FIG. 4

MES—FET

PIN – Photodiode

h·f

P

p⁺-InP
n⁺-InP
n⁻-GaInAsP
n⁺-InP
n⁻-InP

G  D  S

Oxid

InP:Fe

h·f

FIG. 3